# EUROPEAN PATENT APPLICATION

(11) **EP 3 654 741 A1**
(43) Date of publication of application: **20.05.2020**
(21) Application number: 19208993.6
(22) Date of filing: 13.11.2019
(51) Int. Cl.: H05K 5/06, H05K 7/14

(54) **POWER SUPPLY UNIT FOR EXTERIORS**

(30) Priority: 13.11.2018 IT 201800010294
(71) Applicant: F.A.R.T. S.R.L., 31022 Preganziol (TV) (IT)
(72) Inventor: CRIVELLARO, Renato, 31022 PREGANZIOL (TV) (IT)
(74) Representative: Bellemo, Matteo

(57) **Abstract**

A power supply unit for exteriors (1) of the type comprising: an electronic board (2) which is structured so as to receive at input alternating- or direct- current electric energy, and to provide at output direct-current electric energy; and an outer protective casing that surrounds and protects the electronic board (2) from impacts and atmospheric agents; the power supply unit (1) being characterised in that the outer protective casing basically consists of a solid and compact composite-material block (3) having a monolithic structure and which is made of a resin loaded with grains and, optionally, powders of one or more mineral-type inert materials, and in that the electronic board (2) is completely embedded inside said solid and compact composite-material block (3).

## Description

### CROSS-REFERENCE TO RELATED APPLICATIONS

This patent application claims priority from Italian patent application no. 102018000010294 filed on November 13, 2018.

### TECHNICAL FIELD

The invention relates to a power supply unit for exteriors.

More in detail, the invention relates to a switching power supply unit for exteriors, which is adapted to supply electric energy to LED lighting apparatuses for exteriors. Use to which the following disclosure will make explicit reference without however losing in generality.

### BACKGROUND ART

As it is known, switching power supply units for exteriors are AD/DC converters that are adapted to be interposed between a single-phase electrical mains and a generic LED lighting apparatus or any other type of electrical load requiring direct-current power supply; that are capable of converting the alternating-current electric energy coming from the electrical mains into a direct-current electric energy suitable to power the aforementioned electrical load; and that, finally, are specifically structured to be installed and to operate outdoors, resisting bad weather.

The switching power supply units for exteriors currently available on the market basically consist of a rigid, nearly parallelepiped-shaped, box-like outer shell or covering which is usually made of metal material; of an electronic board that accommodates all components needed to carry out an AC/DC conversion of the electric energy and is located inside the box-like shell nearly at the centre thereof; and of a semi-solid and semi-rigid core made of a thermally conductive and electrically insulating silicone-gel, which completely fills the space inside the box-like shell incorporating the electronic board inside itself, so as to immobilize the electronic board inside the shell and, at the same time, electrically insulate the electronic board from the outside.

In other words, the box-like shell made of metal material protects the electronic board against impacts and mechanical stresses, whereas the core made of insulating silicone-gel prevents water and humidity from reaching the electronic board.

The above-mentioned switching power supply units are finally provided with two input connectors that are arranged on the outside of the box-like shell and are electrically connected to the electronic board so as to connect the electronic board to the external electrical mains; and with two output connectors that are arranged on the outside of the box-like shell, usually on the opposite side relative to the two input connectors, and are electrically connected to the electronic board so as to connect the electronic board to the LED lighting apparatus to be powered.

Unfortunately, even though the silicone-gel core is made of a thermal-conductive material, experimental tests have shown that, occasionally, inside the box-like shell there can be an anomalous temperature distribution that, in a very short time, makes the power supply unit unusable.

More in detail, experimental tests have shown that an unforeseen and excessive overheating occasionally takes place in some areas of the electronic board, which very often leads to a quick breaking of the electronic components that are more sensitive to high temperatures. This anomalous temperature distribution seems to be caused/ triggered by an imperfect contact between the silicone-gel core and the inner surface of the shell.

### DISCLOSURE OF INVENTION

Aim of the present invention is to eliminate the local overheating problems described above, while reducing at the same time the manufacturing costs of the switching power supply units for exteriors.

In compliance with these aims, according to the present invention there is provided a power supply unit for exteriors as defined in Claim 1 and preferably, though not necessarily, in any one of the claims depending on it.

### BRIEF DESCRIPTION OF THE DRAWINGS

The invention will now be described with reference to the accompanying drawings, which show a non-limiting embodiment thereof, wherein:
- Figure 1 is an isometric view of a power supply unit for exteriors realized according to the teachings of the present invention, with parts in transparency and parts removed for clarity's sake; whereas
- Figure 2 is a cross-sectional view of the power supply unit shown in Figure 1, with parts removed for clarity's sake.

### BEST MODE FOR CARRYING OUT THE INVENTION

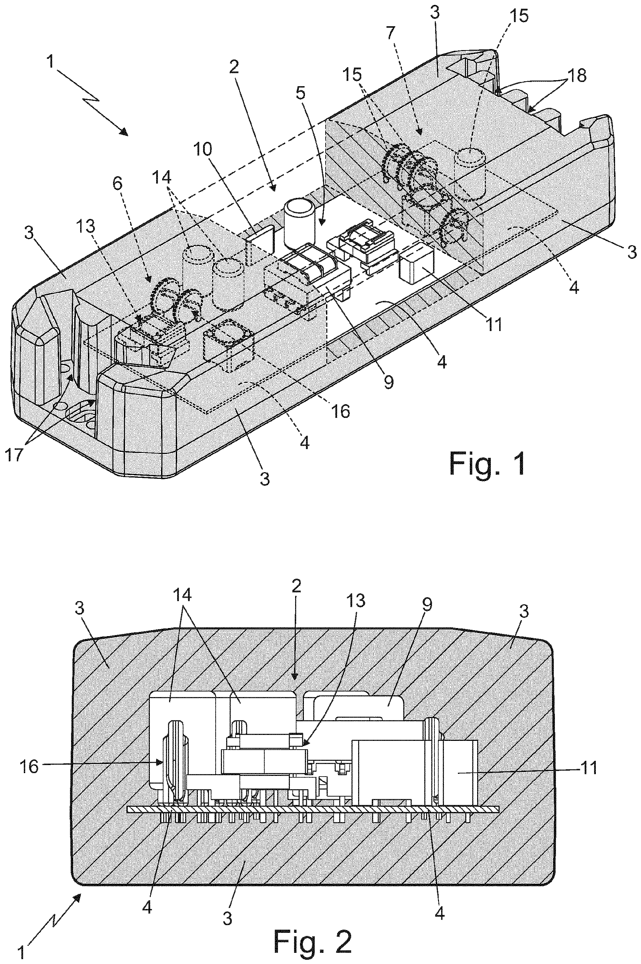

With reference to figures 1 and 2, number 1 denotes as a whole a power supply unit for exteriors that can advantageously be used for powering LED lighting apparatuses for exteriors.

More in detail, the power supply unit 1 is adapted to be interposed between a known single-phase electrical mains and a generic LED lighting apparatus or the like, and is capable of converting the alternating-current electric energy coming from the electrical mains into direct-current electric energy suitable for powering a LED lighting apparatus or any other electrical load that needs direct-current stabilized power supply.

Power supply unit 1, in addition, is specifically structured to be installed and continuously operate outdoors, resisting bad weather.

More in detail, power supply unit 1 is basically made up of an electronic board 2, which is structured so as to receive at input the alternating-current electric energy preferably coming from a generic external single-phase electrical mains, and to provide at output direct-current electric energy preferably with a constant (stabilized) voltage and/or current; and of a protective outer casing which is hard and rigid and surrounds and protects the electronic board 2 from impacts and atmospheric agents.

Clearly power supply unit 1 can also be used indoors, i.e. inside buildings and the like.

Unlike currently known power supply units for exteriors, the outer protecting casing basically consists of, or anyway comprises, a solid and compact composite-material block 3 with a monolithic structure, which is made of a resin loaded with grains and, optionally, also powders of one or more inert materials of mineral type, with sizes of the grains preferably smaller than 5 mm (millimetres); and electronic board 2 is completely embedded inside said solid and compact composite-material block 3.

Preferably the amount of grains and, optionally, also powders of mineral-type inert material/s is furthermore greater than 30% and, optionally, also greater than 50% of the overall weight of the composite material that forms the solid and compact composite-material block 3.

More in detail, the resin is preferably a thermosetting resin and is preferably loaded with grains and, optionally, also powders of quartz (silicon dioxide), feldspar or other mineral. In addition or as an alternative, the composite material can also comprise grains and/or powders of marble and/or granite and/or other stone materials.

In addition, the sizes of the inert-material grains embedded in the resin preferably are less than 3 mm (millimetres). Preferably, the sizes of the inert-material grains embedded in the resin are furthermore greater than 25 µm (micrometres).

In other words, the sizes of the inert-material grains preferably range from 25 µm (micrometres) to 3 mm (millimetres).

In addition, the solid and compact composite-material block 3 is preferably substantially parallelepiped in shape, and the electronic board 2 is preferably arranged substantially at centre of the solid and compact composite-material block 3.

In the example shown, in particular, the solid and compact composite-material block 3 is preferably shaped like an ingot, and is preferably made of a thermosetting resin loaded with quartz grains and powders with sizes preferably ranging from 25 µm (micrometres) to 3 mm (millimetres).

Preferably, the thermosetting resin is furthermore an epoxy-based resin. More in detail, the thermosetting resin is preferably a cycloaliphatic epoxy resin.

With reference to Figures 1 and 2, the electronic board 2, in turn, comprises a printed circuit 4 preferably substantially rectangular in shape, and a series of known electric/electronic components that are suitably fixed on the printed circuit 4.

The assembly of electric/electronic components is adapted to convert the alternating-current electric energy coming from the external electrical mains into a direct-current electric energy suitable for powering LED lighting apparatuses or any other electrical load requiring direct-current power supply.

More in detail, electronic board 2 preferably comprises: an AC/DC conversion module 5 of the switching type, which is adapted to convert the alternating-current electric energy coming from the external electrical mains into a direct-current electric energy, and which is preferably arranged in the central area of the printed circuit 4; and two filtering circuits 6 and 7, which are located on the printed circuit 4 upstream and downstream, respectively, of the AC/DC conversion module 5 and are structured to reduce/minimise high-frequency noises that occur at the input and at the output, respectively, of the AC/DC conversion module 5.

Preferably, the AC/DC conversion module 5 in turn comprises: a small shell-type transformer 9; a MOSFET switch 10; a rectifier 11; and a microprocessor (not shown in the figures) which commands the MOSFET switch 10.

On the other hand, the filtering circuit 6 preferably comprises a passive EMI filter 13 and a series of preferably electrolytic and/or ceramic, capacitors 14 that are suitably connected to one another.

Similarly, the filtering circuit 7 preferably comprises a series of preferably electrolytic and/or ceramic, capacitors 15 that are suitably connected to one another.

With reference to Figure 1, preferably the electronic board 2 finally also comprises an overvoltage protection circuit 16 that is located upstream of the AC/DC conversion module 5 or of the filtering circuit 6, and is adapted to prevent that possible overvoltages arriving from the single-phase electrical mains may irreparably damage the electronic board 2.

The power supply unit 1 is finally provided with input connectors 17 that are located on the outside of the solid and compact composite-material block 3 and are electrically connected to the input terminals of electronic board 2, so as to connect the electronic board 2 to the external electrical mains; and with output connectors 18 that are located on the outside of the solid and compact composite-material block 3, preferably on the opposite side relative to the input connectors 17, and are electrically connected to the output terminals of electronic board 2, so as to connect the electronic board 2 to the LED lighting apparatus or other electrical load requiring direct-current power supply.

In the example shown, in particular, input connectors 17 and output connectors 18 are preferably located at the two axial ends of the substantially ingot-shaped, solid and compact composite-material block 3.

Operation of power supply unit 1 is easily inferable from the description above and, therefore, does not need further explanations, except for pointing out that the solid and compact composite-material block 3 is made of a hard and rigid material which is electrically insulating and also waterproof.

The advantages connected to the particular structure of the outer protective casing are remarkable.

First of all, the power supply unit 1 has relatively low manufacturing costs.

The production of power supply unit 1, in fact, involves, in sequence, the steps of pouring the resin loaded with grains and, optionally, also powders of one or more inert-type mineral materials into a mould which is complementary in shaped to the solid and compact composite-material block 3, and which already accommodates the electronic board 2; and then subjecting the mould and the content thereof to a thermal baking cycle causes the polymerization/cross-linking and hardening of the resin.

In addition, the power supply unit 1 does not need any more an protective outer shell made of metal material.

In fact, since it is made of a hard and rigid material that is moreover electrically insulating and waterproof, the solid and compact composite-material block 3 is capable of protecting the electronic board 2 against impacts and bad weather, ensuring at same time an ideal dissipation of the heat that is normally produced by the electronic board 2.

Finally, the particular monolithic structure of the solid and compact composite-material block 3 has a thermal resistance significantly lower than the overall thermal resistance of the silicone-gel and metal combination, thus improving dissipation of the heat produced by electronic board 2.

It is finally clear that changes and variants may be made to the power supply unit 1 described above, without however extending beyond the scope of the present invention.

For example, the electronic board 2 may comprise two or more printed circuits 4 arranged beside and electrically connected to one another, and the electric/electronic components are suitably spread among the two or more printed circuits 4.

In addition, the electronic board 2 may also receive, at input, direct-current electric energy coming, for example, from a known high-voltage and/or high-capacity battery pack, always providing, at output, direct-current electric energy preferably with a constant voltage and/or current.

## Claims

1. A power supply unit for exteriors (1) of the type comprising: an electronic board (2) which is structured so as to receive at input alternating- or direct- current electric energy, and to provide at output direct-current electric energy; and an outer protective casing that surrounds and protects the electronic board (2) from impacts and atmospheric agents;
the power supply unit (1) being **characterised in that** the outer protective casing comprises a solid and compact composite-material block (3) having a monolithic structure and which is made of a resin loaded with grains of one or more inert materials of a mineral type; **and in that** the electronic board (2) is completely embedded inside said solid and compact composite-material block (3).

2. Power supply unit according to Claim 1, wherein the sizes of the inert-material grains embedded in the resin are less than 5 mm.

3. Power supply unit according to Claim 2, wherein the sizes of the inert-material grains embedded in the resin are less than 3 mm.

4. Power supply unit according to Claim 2 or 3, wherein the sizes of the inert-material grains embedded in the resin are greater than 25 µm.

5. Power supply unit according to any one of the preceding claims, wherein the resin is a thermosetting resin.

6. Power supply unit according to Claim 5, wherein the resin is an epoxy-based resin.

7. Power supply unit according to any one of the preceding claims, wherein the inert material comprises one or more minerals and/or stone materials.

8. Power supply unit according to Claim 7, wherein the inert material comprises quartz.

9. Power supply unit according to any one of the preceding claims, wherein the amount of mineral-type inert-material grain/s is greater than 30% of the overall weight of the composite material that forms the solid and compact composite-material block (3).

10. Power supply unit according to any one of the preceding claims, wherein the electronic board (2) comprises at least one printed circuit (4) and a series of electric/electronic components (9, 10, 11, 13, 14, 15) fixed onto said printed circuit (4).

11. Power supply unit according to Claim 10, wherein the electronic board (2) comprises: an AC/DC conversion module (5) of the switching type, which is adapted to convert alternating-current electric energy into direct-current electric energy; and two filtering circuits (6, 7) that are respectively located upstream and downstream of the AC/DC conversion module (5), and are structured so as to reduce/ minimise high-frequency noises that respectively occur at input and at output of the AC/DC conversion module (5).

12. Power supply unit according to any one of the preceding claims, **characterised by** additionally comprising input connectors (17) and output connectors (18) which are located outside of the solid and compact composite-material block (3) and are electrically connected to the electronic board (2) .
